# EUROPEAN PATENT SPECIFICATION

(11) **EP 4 002 433 B1**
(45) Date of publication and mention of the grant of the patent: **10.05.2023**
(21) Application number: 21194938.3
(22) Date of filing: 03.09.2021
(51) Int. Cl.: H01L 21/67

(54) **SPIN RINSE DRYER WITH IMPROVED DRYING CHARACTERISTICS**
SCHLEUDER-, SPÜL- UND TROCKNERMODUL MIT VERBESSERTEN TROCKNUNGSEIGENSCHAFTEN
MODULE ROTATIF DE RINCAGE ET DE SÉCHAGE AVEC DES CARACTÉRISTIQUES DE SÉCHAGE AMÉLIORÉES

(30) Priority: 17.11.2020 GB 202018030
(43) Date of publication of application: 25.05.2022
(73) Proprietor: SPTS Technologies Limited, Newport Gwent NP18 2TA (GB)
(72) Inventor: THOMAS, Trevor, Newport (GB); AYRES, Martin, Newport (GB)
(74) Representative: Wynne-Jones IP Limited

(56) References cited:
- EP-A1- 1 848 025
- US-A1- 2013 125 931
- US-A1- 2015 090 694
- US-A1- 2017 186 599

## Description

The invention is concerned with a spin rinse dryer, and more particularly to a spin rinse dryer provided with means to reduce the chance of unwanted contamination.

Spin rinse dryers (SRDs) are commonly used in the semiconductor industry and related industries to clean substrates. They can be used as stand-alone units or can be integrated into a larger system which includes additional systems for carrying out other functions (for example, wet etch systems, photoresist systems, or electrochemical deposition systems).

A common function of SRDs is the cleaning and drying of (typically circular) workpieces or (particularly in the semiconductor industry) wafer substrates. During a cleaning step, a cleaning fluid (typically an aqueous solution) is sprayed at the wafer while the wafer is rotated at a relatively low speed (typically 50 to 200 rpm) in a horizontal plane. Usually, this takes place within a chamber or enclosure, which prevents escape of liquid spray and ensures that the wafer is retained in a controlled environment. The process volume is typically purged with an inert gas (such as N₂) from above the wafer to aid fluid flow within the chamber. Once the cleaning fluid has removed the contaminants from the wafer, the fluid flow is stopped, and the wafer is spun at high speed (up to around 2000 to 2500 rpm) to facilitate wafer drying before coming to rest ready for retrieval and movement onward to further process steps.

In some critical process steps, such as a final clean prior to the return to a cassette or front opening unified pod (FOUP), it is essential that this "wash and dry" process has not only cleaned the wafer adequately, but also that the wafer is completely dry on retrieval from the SRD chamber. The presence of aqueous droplets on the wafer surface can lead to damage of the devices on the substrate; for example, if the layer being cleaned is a metal such as copper, an aqueous droplet could cause corrosion or excessive oxidation of the surface of the substrate. This is undesirable as it could result in yield loss.

There are a number of benefits, such as cost, productivity and yield, of integrating a number of process steps into a single automated system. In the case of an electrochemical deposition system, a process sequence could involve a pre-clean step, followed by a number of metal deposition steps, and several post-deposition wafer clean steps before returning to the wafer cassette or FOUP.

When relatively thick (several microns) metal deposition steps are required for (for example) bump metallization, a relatively large number of modules (more than ten deposition stations) are required for production systems to be cost effective. Minimizing footprint in the context of semiconductor capital equipment is important, as clean room space is expensive and thus the footprint of a tool is a key contributor to the overall tool cost of ownership. This has led to the approach of "stacking" process modules vertically to improve productivity while minimizing clean room footprint. For example, US 9421617 shows (in Figure 2 of that document) an arrangement in which one SRD module is arranged above a second SRD module.

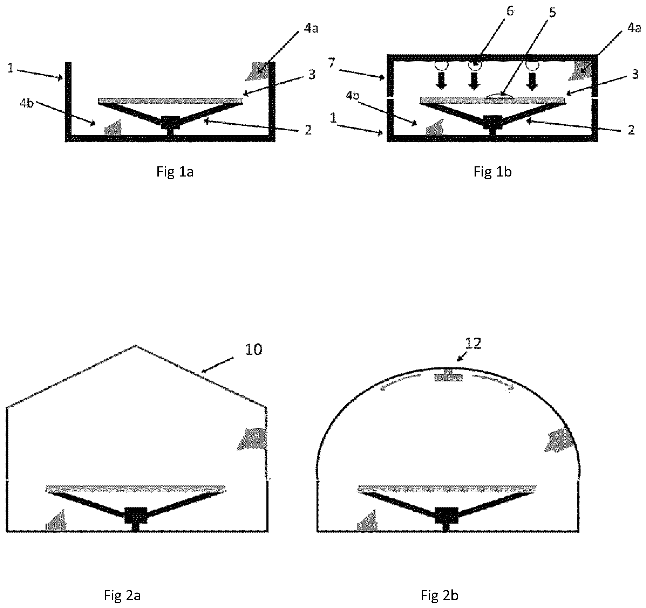

Figures 1a and 1b show schematic representations of a conventional bowl type SRD, similar to the type shown in US 6497241. In Figure 1a, the top of the chamber 1 is open, so that the wafer 3 can be inserted into and removed from the chamber 1 from above. In Figure 1b, the chamber 1 has a flat lid 7 to provide an enclosure. The wafer 3 may be inserted into and removed from the chamber 1 via a slit in the side wall; alternatively, the lid 7 may be removed, so that the wafer 3 can be inserted and removed in a similar manner to the arrangement shown in Figure 1a.

Chamber 1 is typically made from a polymeric material such as high-density polyethylene (HDPE), polytetrafluoroethylene (PTFE), perfluoroalkoxy alkanes (PFA), polyvinyl chloride (PVC) or the like. The choice of material will largely depend on the nature of the cleaning fluid being used to process the wafer. Some cleaning fluids are not compatible with conventional polymer materials, and if these fluids are used, stainless steel or another metal could be used to fabricate the chamber.

The chamber has a rotor assembly 2 which retains the wafer 3 and can be controlled to rotate at speeds up to around 3000 rpm. A spray nozzle or a series of spray nozzles 4a are located above the plane of the wafer 3 and are directed at the front surface of the wafer. Similarly, a spray nozzle or a series of spray nozzles 4b are located below the plane of the wafer 3 and are directed at the back surface of the wafer.

Fluid from the nozzles 4a, 4b strikes the wafer 3, is flung away from the wafer 3 to impact the side walls of the chamber 1 as in a centrifuge, and is removed from an exhaust port (not shown) at the base of the chamber 1. After the washing step, an inert purge gas (such as N₂) can be directed at the wafer 3 to help in drying it. However, ever after the wafer 3 has been dried, some fluid may be retained on the walls of the chamber 1, and in the arrangement of Figure 1b, it is possible for droplets 6 to form on the lower surface on the chamber lid 7. These droplets could fall on the wafer 3 during the removal of the wafer 3 from the chamber 1, and contaminate the wafer 3.

Clearly, this problem does not arise in the arrangement of Figure 1a, as there is no lid on which droplets could form. However, the arrangement of Figure 1a is not compatible with a low profile SRD module design; if a number of SRDs as shown in Figure 1a were to be vertically stacked, there would need to be a large gap between modules to avoid droplets forming on the lower surface of the upper module.

Alternative approaches have been proposed to deal with the problem of droplet formation on the lower surface of the lid. For example, US 9421617 (mentioned above) shows an arrangement where the lid 10 is formed in a conical shape (shown schematically in Figure 2a), so that the droplets will tend to run downwards and radially outwards, away from the wafer. This effect can be increased by forming the lower surface of the lid as a hydrophobic surface. Figure 2b shows an arrangement where the lid 12 is formed as a dome, which again may have a hydrophobic lower surface. A nozzle for purge gas can be provided at the top of the dome 12 to direct inert purge gas (such as N₂) along the inner surface of the dome 12 to push the droplets radially outwards and away from the wafer.

However, both of these arrangements require considerable vertical space above the wafer, and so they are not well suited to high density vertical chamber stacking.

US 2015/090694 A1 discloses a substrate processing apparatus that processes a circular semiconductor wafer by using a processing liquid and a rinse liquid. The substrate processing apparatus includes a lower substrate holding mechanism that rotates a wafer while holding the wafer in a horizontal posture from the lower side, an upper substrate holding mechanism that is disposed above the lower substrate holding mechanism and rotates the wafer while holding the wafer in a horizontal posture, which are arranged in a processing chamber defined by a partition wall. The upper substrate holding mechanism includes an upper rotational shaft having the rotation axis which is common to the lower rotational shaft, a disk-shaped upper spin base attached to a lower end of the upper rotational shaft in a horizontal posture, and a plurality of upper gripping members disposed at a peripheral edge of the upper spin base.

Accordingly, it is an object of the invention to provide a low-profile spin rinse dryer capable of high density vertical stacking, with a reduced risk of contamination of the wafer after cleaning and drying.

According to a first aspect of the invention, there is provided a spin rinse dryer for treating a substrate according to claim 1.

During cleaning of the wafer, any liquid that splashes up from the wafer will strike the lower surface of the rotatable member, rather than the upper wall of the enclosure, and may form droplets on the rotatable member. After the flow of cleaning liquid has stopped, the drive can rotate the rotatable member at high speed, which tends to throw the liquid droplets off the lower surface of the rotatable member through centrifugal force. The liquid then runs down the walls of the enclosure, away from the wafer, so that there is a much reduced chance of contamination of the cleaned wafer.

It is an advantage of the invention that the spin rinse dryer can be provided as a low profile spin rinse dryer. A low profile spin rinse dryer of the invention can be of vertical height 300mm or less. This is particularly suitable for applications in which modules are vertically stacked.

The lower surface of the rotatable member may be arranged to be substantially parallel to an upper surface of a substrate when that substrate is supported by the rotatable support.

The rotatable support may be connected to the rotatable member such that the rotatable support and the rotatable member rotate together. A number of arms may extend downwards from the rotatable member, and a prong may extend radially inwardly from the lower end of each arm, the prongs acting as the rotatable support. There may be three circumferentially equispaced arms.

The drive may be located alongside the enclosure, and may be connected to the rotatable member and the rotatable support so as to drive them to rotate.

The rotatable support and the rotatable member may be unconnected to each other, and may rotate separately. The rotatable support and the rotatable member may be arranged to rotate about a common axis. A single drive may be located alongside the enclosure, and may be connected to both the rotatable member and the rotatable support so as to drive them to rotate. The drive may be connected to the rotatable member and the rotatable support via a telescopic shaft. In another arrangement, two drives may be located alongside the enclosure; a first of the drives may be connected to the rotatable member so as to drive it to rotate, and a second of the drives may be connected to the rotatable support so as to drive it to rotate.

The enclosure and the rotatable member may both be circular in plan view. The diameter of the rotatable member may be slightly less than the internal diameter of the enclosure. The diameter of the rotatable member may be greater than the diameter of the substrate to be treated.

The rotatable member may be formed from a hydrophobic material, such as polycarbonate.

The rotatable member may be formed as a single part.

The rotatable member may be formed with reinforcing features such as ribs.

The spin rinse dryer may be provided with nozzles located above and below the rotatable support for directing liquid toward a substrate located on the rotatable support.

The spin rinse dryer may be capable of operating at pressures below atmospheric pressure.

The spin rinse dryer may have a vertical height of less than around 300mm.

The invention also extends to an apparatus for processing a substrate comprising a stack of substrate processing modules in which at least one of the modules is a spin rinse dryer as described above.

According to a further aspect of the invention, there is provided a method of treating a substrate according to claim 15.

The substrate may be a semiconductor substrate, such as a semiconductor wafer.

Whilst the invention has been described above, it extends to any combination of the features set out above, or in the following description, drawings or claims. For example, any features disclosed in relation to one aspect of the invention may be combined with any features disclosed in relation to any other aspect of the invention.

Preferred embodiments of the invention will now be described by way of example only and with reference to the accompanying drawings, in which:
Figures 1a and 1b are schematic views of prior art spin rinse dryers;
Figures 2a and 2b are schematic views of prior art spin rinse dryers which includes means aimed at reducing contamination of a cleaned wafer;
Figure 3 is a schematic cross-sectional view of a first embodiment of a spin rinse dryer according to the invention;
Figure 4 is a side view of a spin rinse dryer according to the invention; and
Figures 5a and 5b are schematic cross-sectional views similar to Figure 3, showing alternative drive means.

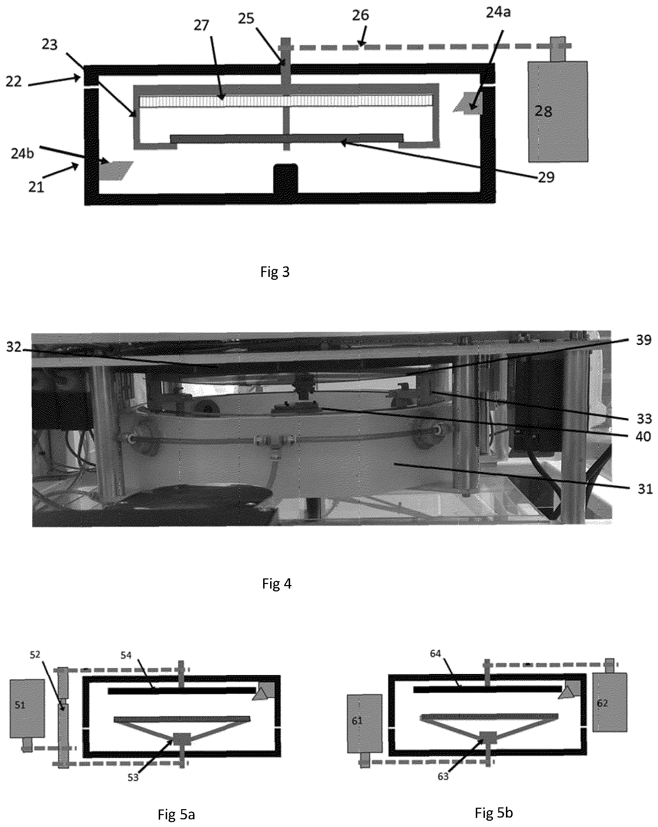

Figure 3 shows a first embodiment of the invention. The spin rinse dryer of Figure 3 includes an enclosure formed by a main body 21 and a lid 22, with a rotatable support 23 for the wafer 29. Located above the wafer 29 and below the lid 22 of the enclosure is a rotatable member 27, in the form of a disc with a continuous lower surface. Any liquid that splashes up from the wafer 29 during cleaning will strike the lower surface of the rotatable member 27, rather than the lid 22 of the enclosure, so droplets will form on the rotatable member 27 instead of the lid 22. The rotatable member 27 can then be rotated to remove the droplets from the lower surface via centrifugal force.

In the specific version shown in Figure 3, the rotatable support 23 for the wafer 29 and the rotatable member 27 are formed integrally. Three circumferentially equispaced arms extend downwards from the rotatable member 27, and the wafer 29 is supported on three prongs which extend radially inwardly from the lower ends of the arms. The rotatable member 27, and thus the arms and prongs, are rotated by a central shaft 25 which extends vertically through the lid 22 of the enclosure. The central shaft 25 is powered to rotate by means of a motor 28 located to one side of the chamber, with the shaft of the motor 28 extending vertically and being connected to the central shaft 25 by a belt drive 26. Arranging the drive means alongside the enclosure reduces the overall height of the spin rinse dryer.

During wafer cleaning, the rotatable member 27 and the rotatable support 23 for the wafer 29 are rotated (typically at 50 to 200 rpm) while cleaning fluid is sprayed from nozzles 24a and 24b. All of the internal surfaces of the chamber will be wetted with scattered spray, and this has the potential to form hanging liquid droplets (similar to those shown in Figure 1b), which could fall on to the wafer 29.

Once the wafer 29 has been washed, the fluid supply is turned off and the wafer 29 is dried by rotation at high speed (typically 2000 to 2500 rpm). An inert drying purge gas such as nitrogen can also be used. During this high speed rotation, not only is the wafer 29 dried (by centrifugal forces moving water radially away from the wafer 29), but so is the rotatable member 27 which is located directly above the wafer 29. The droplets formed on the rotatable member 27 will be thrown off by centrifugal force. When the rotation ends, there should be no drops of liquid above the wafer 29, and so there should be no risk of liquid dripping onto the wafer 29. Furthermore, this is achieved in a low profile package (that is, with minimal vertical height).

Typically, the rotatable member 27 has a larger diameter than the wafer 29; for example, if the wafer 29 has a diameter of 300mm, the rotatable member 27 would have a diameter of 320mm. Further, the rotatable member 27 should extend as close as possible to the chamber walls, and preferably to within at most 10mm of the chamber walls. This further reduces the risk of liquid dripping from the lower surface of the lid 22 of the chamber onto the wafer 29. Drainage channels for fluid can be located near the chamber walls. In addition, the top of the rotatable member 27 should be positioned close to the lower surface of the lid 22 of the chamber (to reduce the risk of spray from the nozzles hitting the lower surface of the lid 22 of the chamber), and is preferably positioned within 3mm of the lower surface of the lid 22 of the chamber.

Figure 4 shows a low profile spin rinse dryer with the chamber open to allowing loading or unloading of a wafer. In this case, the lower part 31 of the chamber moves away from the upper part 32, which is fixed, but it would also be possible for the lower part 31 of the chamber to be fixed and for the upper part of the chamber to be moved 32. This opening and closing movement can be achieved using electric motors or pneumatic or hydraulic pistons.

When the chamber is open, the wafer 39 can be inserted into or removed from the rotatable support 33. The inner diameter between the holding arms must be greater than the diameter of the wafer 39 to allow the wafer 39 to be placed into the chamber and onto the rotatable support 33. Furthermore, if notch alignment is required, then the position of the wafer 39 in the rotatable support 33 needs to be rotationally aligned before wafer loading or unloading can occur. This is achieved by a central lift pillar 40 which lifts the wafer 39 from the rotatable support 33 and enables the alignment of a notch or flat on the wafer 39 to a defined orientation on the rotatable support prior to the unloading step.

The particular version of the chamber in Figure 4 has a maximum height when opened of around 215mm; this allows the chambers to be stacked with a pitch of around 225mm, leading to an efficient use of space.

The invention is not limited to the specific drive arrangement shown in Figure 3. Figure 5a shows a variant in which the rotatable support 53 and the rotatable member 54 are separate bodies arranged to rotate about a common axis. The rotatable support 53 for the wafer supports the wafer from below, which may simplify the procedure of loading and unloading the wafer. The rotatable support 53 and rotatable member 54 are driven by a single motor 51, and are connected thereto via a telescopic shaft coupling 52 (the telescopic aspect is necessary to allow the upper and lower parts of the chamber to move away from each other to open the chamber). Figure 5b shows an alternative version in which separate motors 61, 62 are provided for the rotatable support 63 and the rotatable member 64, which again are arranged to rotate about a common axis. As with the embodiment shown in Figure 3, the motor or motors 61, 62 are arranged to the side of the chamber, to keep the overall height as low as possible.

By forming the rotatable support and the rotatable member as two distinct entities, it is possible to reduce the overall size of the rotor assembly, which in turn can result in a chamber with a smaller diameter. The arrangements shown in Figures 5a and 5b can also allow more process flexibility for cleaning and drying the wafer, as they both allow the rotatable support and the rotatable member to be rotated at different speeds. Further, the arrangement shown in Figure 5b allows the rotatable support and the rotatable member to be spun independently of each other.

When operating with two drive assemblies, the rotatable member will typically have a maximum speed less than that of the wafer (less than or equal to around 1000rpm), as it contains no surface morphology which needs to be dried, and only requires the removal of larger droplets of liquid. If the process uses a deionized water clean, then the rotatable member can be made from a hydrophobic plastic material, such as polycarbonate, although the choice of material will of course be dependent on compatibility with the process chemistry.

The rotatable member will typically be machined or moulded as a single part, to ensure mechanical robustness. Further, the rotatable member may be formed with ribs or similar reinforcing features radiating out from the centre to increase its rigidity.

Figures 3, 5a and 5b only show a limited number of wetting nozzles. In reality, a spin rinse dryer will feature several wetting nozzles able to access both the upper and lower surfaces (front and back) of the wafer. Different flow rates, drive pressures and spray shapes of the nozzles can be used, depending on the process requirements. Common options for spray shape are fans and solid cones. Typical nozzle flow rates are 1 litre per minute at 35 psi (around 240 kPa), and so a spin rinse dryer using four fluid nozzles would run at 4 litres per minute.

The chamber may be sealed during water delivery, which can allow wafers to be processed at pressures below atmospheric, typically 10 to 100 Torr (around 133 to 1330 Pa).

Although only specific embodiments of the invention have been described, the skilled person will appreciate that the invention is not limited to these embodiments, and that variations can be made within the scope of the appended claims.

## Claims

1. A spin rinse dryer for treating a substrate (29), including:
an enclosure formed by a main body (21) and a lid (22);
a rotatable support (23,53,63) located within the enclosure for supporting the substrate;
a rotatable (27,54,64) located within the enclosure above the rotatable support, the rotatable member having a continuous lower surface and a top, wherein the top of the rotatable member is positioned close to a lower surface of the lid; and
a drive (28,51,62) for rotating the rotatable member.

2. A spin rinse dryer as claimed in claim 1, wherein the lower surface of the rotatable member is arranged to be substantially parallel to an upper surface of a substrate when that substrate is supported by the rotatable support.

3. A spin rinse dryer as claimed in claim 1 or claim 2, wherein the rotatable support is connected to the rotatable member such that the rotatable support and the rotatable member rotate together.

4. A spin rinse dryer as claimed in claim 3, wherein a number of arms extend downwards from the rotatable member, and a prong extends radially inwardly from the lower end of each arm, the prongs acting as the rotatable support and optionally wherein there are three circumferentially equispaced arms.

5. A spin rinse dryer as claimed in any of claims 3 to 4, wherein the drive is located alongside the enclosure, and is connected to the rotatable member and the rotatable support so as to drive them to rotate.

6. A spin rinse dryer as claimed in claim 1, wherein the rotatable support and the rotatable member are not connected to each other, and rotate separately and optionally wherein the rotatable support and the rotatable member are arranged to rotate about a common axis.

7. A spin rinse dryer as claimed in claim 6, wherein a single drive is located alongside the enclosure, and is connected to both the rotatable member and the rotatable support so as to drive them to rotate.

8. A spin rinse dryer as claimed in claim 7, wherein the drive is connected to the rotatable member and the rotatable support via a telescopic shaft.

9. A spin rinse dryer as claimed in claim 6, wherein two drives are located alongside the enclosure, a first of the drives being connected to the rotatable member so as to drive it to rotate, and a second of the drives being connected to the rotatable support so as to drive it to rotate.

10. A spin rinse dryer as claimed in any preceding claim, wherein: i) the enclosure and the rotatable member are both circular in plan view; and/or ii) the diameter of the rotatable member is slightly less than the internal diameter of the enclosure; and/or iii) the diameter of the rotatable member is greater than the diameter of the substrate to be treated.

11. A spin rinse dryer as claimed in any preceding claim, wherein: i) the rotatable member is formed from a hydrophobic material, such as polycarbonate; and/or ii) the rotatable member is formed as a single part; and/or iii) the rotatable member is formed with reinforcing features such as ribs; and/or iv) the spin rinse dryer is provided with nozzles located above and below the rotatable support for directing liquid toward a substrate located on the rotatable support.

12. A spin rinse dryer as claimed in any preceding claim, wherein the spin rinse dryer is capable of operating at pressures below atmospheric pressure.

13. A spin rinse dryer as claimed in any preceding claim, wherein the vertical height of the spin rinse dryer is less than around 300mm.

14. An apparatus for processing a substrate comprising a stack of substrate processing modules in which at least one of the modules is a spin rinse dryer as claimed in any preceding claim.

15. A method of treating a substrate (29), comprising:
supporting a substrate on a rotatable support (23,53,63) in an enclosure formed of a main body (21) and a lid (22), wherein the rotatable support is positioned below a rotatable member (27,54,64) having a continuous lower surface and a top, wherein the top of the rotatable member is positioned close to a lower surface of the lid;
directing liquid at the substrate from nozzles (24a,24b) above and below the rotatable support to wash the substrate;
rotating the rotatable support to remove liquid from the substrate;
rotating the rotatable member to remove liquid from the rotatable member; and
removing the substrate from the enclosure.

## Patentansprüche

1. Rotationsspültrockner zum Behandeln eines Substrats (29), der einschließt:
ein Gehäuse, das durch einen Hauptkörper (21) und einen Deckel (22) ausgebildet ist;
eine drehbare Stütze (23,53,63), zum Stützen des Substrats, die sich innerhalb des Gehäuses befindet;
ein drehbares (27,54,64), das sich innerhalb des Gehäuses oberhalb der drehbaren Stütze befindet, wobei das drehbare Element eine durchgehende untere Oberfläche und eine Oberseite aufweist, wobei die Oberseite des drehbaren Elements nahe einer unteren Oberfläche des Deckels positioniert ist; und
einen Antrieb (28,51,62) zum Drehen des drehbaren Elements.

2. Rotationsspültrockner nach Anspruch 1, wobei die untere Oberfläche des drehbaren Elements angeordnet ist, um im Wesentlichen parallel zu einer oberen Oberfläche eines Substrats zu sein, wenn dieses Substrat durch die drehbare Stütze gestützt wird.

3. Rotationsspültrockner nach Anspruch 1 oder 2, wobei die drehbare Stütze mit dem drehbaren Element derart verbunden ist, dass sich die drehbare Stütze und das drehbare Element zusammen drehen.

4. Rotationsspültrockner nach Anspruch 3, wobei sich eine Anzahl von Armen von dem drehbaren Element nach unten erstreckt und sich ein Zinken von dem unteren Ende jedes Arms nach innen radial erstreckt, wobei die Zinken als die drehbare Stütze wirken und optional, wobei drei umlaufend gleich beabstandete Arme vorhanden sind.

5. Rotationsspültrockner nach einem der Ansprüche 3 bis 4, wobei sich der Antrieb neben dem Gehäuse befindet und mit dem drehbaren Element und der drehbaren Stütze verbunden ist, um sie anzutreiben, um sich zu drehen.

6. Rotationsspültrockner nach Anspruch 1, wobei die drehbare Stütze und das drehbare Element nicht miteinander verbunden sind und sich separat drehen und optional, wobei die drehbare Stütze und das drehbare Element angeordnet sind, um sich um eine gemeinsame Achse zu drehen.

7. Rotationsspültrockner nach Anspruch 6, wobei sich ein einzelner Antrieb neben dem Gehäuse befindet und sowohl mit dem drehbaren Element als auch mit der drehbaren Stütze verbunden ist, um sie anzutreiben, um sich zu drehen.

8. Rotationsspültrockner nach Anspruch 7, wobei der Antrieb mit dem drehbaren Element und der drehbaren Stütze über eine Teleskopwelle verbunden ist.

9. Rotationsspültrockner nach Anspruch 6, wobei zwei Antriebe sich neben dem Gehäuse befinden, wobei ein erster der Antriebe mit dem drehbaren Element verbunden ist, um es anzutreiben, um sich zu drehen, und ein zweiter der Antriebe mit der drehbaren Stütze verbunden ist, um sie anzutreiben, um sich zu drehen.

10. Rotationsspültrockner nach einem der vorstehenden Ansprüche, wobei: i) das Gehäuse und das drehbare Element in Draufsicht beide kreisförmig sind; und/oder ii) der Durchmesser des drehbaren Elements geringfügig kleiner als der Innendurchmesser des Gehäuses ist; und/oder iii) der Durchmesser des drehbaren Elements größer als der Durchmesser des zu behandelnden Substrats ist.

11. Rotationsspültrockner nach einem der vorstehenden Ansprüche, wobei: i) das drehbare Element aus einem hydrophoben Material, wie etwa Polycarbonat ausgebildet, ist; und/oder ii) das drehbare Element als ein einzelnes Teil ausgebildet ist; und/oder iii) das drehbare Element mit Verstärkungsmerkmalen wie etwa Rippen ausgebildet ist; und/oder iv) der Rotationsspültrockner mit Düsen versehen ist, die sich oberhalb und unterhalb der drehbaren Stütze zum Lenken von Flüssigkeit zu einem Substrat, das sich auf der drehbaren Stütze befindet, befinden.

12. Rotationsspültrockner nach einem der vorstehenden Ansprüche, wobei der Rotationsspültrockner in der Lage ist, bei Drücken unter Atmosphärendruck zu funktionieren.

13. Rotationsspültrockner nach einem der vorstehenden Ansprüche, wobei die vertikale Höhe des Rotationsspültrockners kleiner als etwa 300 mm ist.

14. Vorrichtung zum Verarbeiten eines Substrats, umfassend einen Stapel von Substratverarbeitungsmodulen, in dem mindestens eines der Module ein Rotationsspültrockner nach einem der vorstehenden Ansprüche ist.

15. Verfahren zum Behandeln eines Substrats (29), umfassend:
Stützen eines Substrats auf einer drehbaren Stütze (23,53,63) in einem Gehäuse, das aus einem Hauptkörper (21) und einem Deckel (22) ausgebildet ist,
wobei die drehbare Stütze unterhalb eines drehbaren Elements (27,54,64) positioniert ist, das eine durchgehende untere Oberfläche und eine Oberseite aufweist, wobei die Oberseite des drehbaren Elements nahe einer unteren Oberfläche des Deckels positioniert ist;
Lenken von Flüssigkeit an das Substrat von Düsen (24a,24b) oberhalb und unterhalb der drehbaren Stütze, um das Substrat zu waschen;
Drehen der drehbaren Stütze, um Flüssigkeit aus dem Substrat zu entfernen;
Drehen des drehbaren Elements, um Flüssigkeit aus dem drehbaren Element zu entfernen; und
Entfernen des Substrats aus dem Gehäuse.

## Revendications

1. Rinceuse-sécheuse centrifuge permettant de traiter un substrat (29), comprenant :
une enceinte formée par un corps principal (21) et un couvercle (22) ;
un support rotatif (23, 53, 63) situé à l'intérieur de l'enceinte pour supporter le substrat ;
un élément rotatif (27, 54, 64) situé à l'intérieur de l'enceinte au-dessus du support rotatif, l'élément rotatif ayant une surface inférieure continue et un sommet, le sommet de l'élément rotatif étant positionné à proximité d'une surface inférieure du couvercle ; et
un entraînement (28, 51, 62) pour faire tourner l'élément rotatif.

2. Rinceuse-sécheuse centrifuge selon la revendication 1, dans laquelle la surface inférieure de l'élément rotatif est agencée pour être sensiblement parallèle à une surface supérieure d'un substrat lorsque ce substrat est supporté par le support rotatif.

3. Rinceuse-sécheuse centrifuge selon la revendication 1 ou la revendication 2, dans laquelle le support rotatif est relié à l'élément rotatif de telle sorte que le support rotatif et l'élément rotatif tournent ensemble.

4. Rinceuse-sécheuse centrifuge selon la revendication 3, dans laquelle un nombre de bras s'étend vers le bas à partir de l'élément rotatif, et un fourchon s'étend radialement vers l'intérieur depuis l'extrémité inférieure de chaque bras, les fourchons agissant en tant que support rotatif et éventuellement dans laquelle il y a trois bras espacés à des distances égales et circonférentiellement.

5. Rinceuse-sécheuse centrifuge selon l'une quelconque des revendications 3 à 4, dans laquelle l'entraînement est situé à côté de l'enceinte, et est relié à l'élément rotatif et au support rotatif de manière à les entraîner en rotation.

6. Rinceuse-sécheuse centrifuge selon la revendication 1, dans laquelle le support rotatif et l'élément rotatif ne sont pas reliés l'un à l'autre, et tournent séparément et éventuellement dans laquelle le support rotatif et l'élément rotatif sont agencés pour tourner autour d'un axe commun.

7. Rinceuse-sécheuse centrifuge selon la revendication 6, dans laquelle un entraînement unique est situé à côté de l'enceinte, et est relié à la fois à l'élément rotatif et au support rotatif de manière à les entraîner en rotation.

8. Rinceuse-sécheuse centrifuge selon la revendication 7, dans laquelle l'entraînement est relié à l'élément rotatif et au support rotatif par l'intermédiaire d'une tige télescopique.

9. Rinceuse-sécheuse centrifuge selon la revendication 6, dans laquelle deux entraînements sont situés à côté de l'enceinte, un premier des entraînements étant relié à l'élément rotatif de manière à l'entraîner en rotation, et un second des entraînements étant relié au support rotatif de manière l'entraîner en rotation.

10. Rinceuse-sécheuse centrifuge selon l'une quelconque revendication précédente, dans laquelle : i) l'enceinte et l'élément rotatif sont tous deux circulaires dans une vue en plan ; et/ou ii) le diamètre de l'élément rotatif est légèrement inférieur au diamètre interne de l'enceinte ; et/ou iii) le diamètre de l'élément rotatif est supérieur au diamètre du substrat à traiter.

11. Rinceuse-sécheuse centrifuge selon l'une quelconque revendication précédente, dans laquelle : i) l'élément rotatif est formé à partir d'un matériau hydrophobe, tel que du polycarbonate ; et/ou ii) l'élément rotatif est formé en une seule partie ; et/ou iii) l'élément rotatif est formé avec des éléments de renforcement tels que des nervures ; et/ou iv) la rinceuse-sécheuse centrifuge est pourvue de buses situées au-dessus et en dessous du support rotatif pour diriger le liquide vers un substrat situé sur le support rotatif.

12. Rinceuse-sécheuse centrifuge selon l'une quelconque revendication précédente, dans laquelle la rinceuse-sécheuse centrifuge est capable de fonctionner à des pressions inférieures à la pression atmosphérique.

13. Rinceuse-sécheuse centrifuge selon l'une quelconque des revendications précédentes, dans laquelle la hauteur verticale de la rinceuse-sécheuse centrifuge est inférieure à environ 300 mm.

14. Appareil de traitement d'un substrat comprenant un empilement de modules de traitement de substrat dans lequel au moins l'un des modules est une rinceuse-sécheuse centrifuge selon l'une quelconque revendication précédente.

15. Procédé de traitement d'un substrat (29), comprenant :
le support d'un substrat sur un support rotatif (23, 53, 63) dans une enceinte formée d'un corps principal (21) et d'un couvercle (22),
dans lequel le support rotatif est positionné sous un élément rotatif (27, 54, 64)
ayant une surface inférieure continue et un sommet, le sommet de l'élément rotatif étant positionné à proximité d'une surface inférieure du couvercle ;
le fait de diriger le liquide au niveau du substrat à partir de buses (24a, 24b) au-dessus et en dessous du support rotatif pour laver le substrat ;
la rotation du support rotatif pour éliminer le liquide du substrat ;
la rotation de l'élément rotatif pour retirer le liquide de l'élément rotatif ; et
le retrait du substrat du récipient.
